# EUROPEAN PATENT APPLICATION

(11) **EP 4 636 829 A1**
(43) Date of publication of application: **22.10.2025**
(21) Application number: 23916695.2
(22) Date of filing: 17.01.2023
(51) Int. Cl.: H01L 31/00

(54) **PEROVSKITE BATTERY, PREPARATION METHOD THEREFOR, AND ELECTRICAL APPARATUS**

(71) Applicant: Contemporary Amperex Technology (Hong Kong) Limited, Hong Kong (HK)
(72) Inventor: SU, Shuojian, Ningde, Fujian 352100 (CN); LI, Hanfang, Ningde, Fujian 352100 (CN); LIN, Xiangling, Ningde, Fujian 352100 (CN); ZHANG, Fan, Ningde, Fujian 352100 (CN); CHEN, Guodong, Ningde, Fujian 352100 (CN); GUO, Yongsheng, Ningde, Fujian 352100 (CN)
(74) Representative: Kraus & Lederer PartGmbB
(86) International application number: PCT/CN2023/072683
(87) International publication number: WO 2024/152205

(57) **Abstract**

The present application provides a perovskite battery and a preparation method thereof, and an electrical device, and belongs to the technical field of batteries. The perovskite battery includes a plurality of battery units arranged along a first direction, each battery unit including a first electrode layer, a second electrode layer, and a first perovskite layer between the first electrode layer and the second electrode layer that are arranged along a second direction; and a connection structure that is configured to connect a first electrode layer of a first battery unit to a second electrode layer of a second battery unit that are adjacent among the plurality of battery units. Low-dimensional perovskite layers are disposed on regions on two sides of the connection structure opposite to the first perovskite layers. The solution of the present application is conducive to improving the performance of the perovskite battery.

## Description

### TECHNICAL FIELD

The present application relates to the technical field of batteries, and in particular, to a perovskite battery and a preparation method thereof, and an electrical device.

### BACKGROUND

In recent years, the problems of global energy shortage and environmental pollution are increasingly prominent, and solar batteries as an ideal renewable energy source have attracted more and more attention. The solar batteries, also known as photovoltaic batteries, are an apparatus that directly converts optical energy into electrical energy through a photoelectric effect or a photochemical effect. Perovskite batteries are a new type of solar batteries that has been extensively researched currently. In a few years since its inception, the perovskite batteries have soon achieved relatively high optical-to-electrical conversion efficiency, and enjoy a good application prospect.

However, a perovskite layer in the perovskite battery is unstable and prone to decomposition as well as reacting with metals, which is not conducive to improving performance of the perovskite battery. Therefore, how to improve the performance of the perovskite battery is an urgent technical problem.

### SUMMARY

The present application is made in view of the foregoing problems, and an objective of the present application is to provide a perovskite battery and a preparation method thereof, and an electrical device to improve the efficiency and life of the perovskite battery.

According to a first aspect, the present application provides a perovskite battery, including: a plurality of battery units arranged along a first direction, each battery unit including a first electrode layer, a second electrode layer, and a first perovskite layer between the first electrode layer and the second electrode layer that are arranged along a second direction; and a connection structure that is configured to connect a first electrode layer of a first battery unit to a second electrode layer of a second battery unit that are adjacent among the plurality of battery units. Low-dimensional perovskite layers are disposed on regions on two sides of the connection structure opposite to the first perovskite layers.

An embodiment of the present application provides the perovskite battery, including the plurality of battery units arranged along the first direction and a connection structure. Each battery unit includes the first electrode layer, the second electrode layer, and the first perovskite layer between the first electrode layer and the second electrode layer that are arranged along the second direction. In this way, the battery unit can output power through the first electrode layer and the second electrode layer and absorb sunlight through the first perovskite layer. The connection structure is configured to connect the first electrode layer of the first battery unit to the second electrode layer of the second battery unit that are adjacent among the plurality of battery units, such that the adjacent first battery unit and second battery unit can be electrically connected. The low-dimensional perovskite layers are disposed on the regions on the two sides of the connection structure opposite to the first perovskite layers. On the one hand, halogens in the low-dimensional perovskite layers are not prone to migration and thus not prone to reacting with the connection structure, which can reduce corrosion of the connection structure caused by reacting of the low-dimensional perovskite layers with the connection structure, and thus is conducive to reducing the reduction in efficiency of the perovskite battery caused by the corrosion of the connection structure. Additionally, the first perovskite layers are not in contact with the connection structure, which can reduce decomposition of positions of the first perovskite layers corresponding to the connection structure, and thus is conducive to improving the life of the perovskite battery. On the other hand, the low-dimensional perovskite layers have relatively low electron mobility and hole mobility, which can reduce recombination of a leakage current and carriers in contact parts of the connection structure and the low-dimensional perovskite layers, and thus is conducive to improving the efficiency of the perovskite battery. Therefore, the embodiment of the present application can improve performance of the perovskite battery.

In a possible implementation, the low-dimensional perovskite layers have a structural formula of (NH³⁺-R-NH³⁺)Aₙ₋₁BₙX₃ₙ₊₁ or (R-NH³⁺)₂Aₙ₋₁BₙX₃ₙ₊₁, and n ≤ 5. R includes at least one of phenyl, aryl, alkyl or a piperidine derivative. A includes at least one of Cs, FA, MA, Rb or K; B includes at least one of Pb²⁺ or Sn²⁺. X includes at least one of F⁻, Cl⁻, Br⁻ or I⁻. n is set to be less than or equal to 5, which can not only improve the efficiency and life of the perovskite battery, but also facilitate preparation of the low-dimensional perovskite layers.

In a possible implementation, the perovskite battery further includes a first isolation structure. The first isolation structure is configured to isolate a second electrode layer of the first battery unit from the second electrode layer of the second battery unit, and the first isolation structure is spaced apart from the connection structure. In this way, the second electrode layers of the adjacent battery units are isolated through the first isolation structure; and additionally, spacing the first isolation structure apart from the connection structure is conducive to reducing complexity of a process and reducing the production cost.

In a possible implementation, the battery unit includes the first electrode layer, a first charge transport layer, the first perovskite layer, a second charge transport layer and the second electrode layer that are sequentially disposed on a substrate. In this way, carriers in the perovskite battery can be transported through the first charge transport layer and the second charge transport layer.

In a possible implementation, the first isolation structure is an insulation structure that extends from a first surface of the second electrode layer to at least the first charge transport layer, and the first surface of the second electrode layer is a surface of the second electrode layer away from the first electrode layer. Along the first direction, the low-dimensional perovskite layers are disposed on regions on two sides of the first isolation structure opposite to the first perovskite layers. The low-dimensional perovskite layers have better resistance to water and oxygen erosion, and by disposing the low-dimensional perovskite layers on the regions on the two sides of the first isolation structure opposite to the first perovskite layers, regions of the first perovskite layers corresponding to the first isolation structure can be avoided from exposure, such that corrosion of the first perovskite layers by water and oxygen can be reduced, which is conducive to improving the life and efficiency of the perovskite battery.

In a possible implementation, along the first direction, a distance between the first isolation structure and the connection structure is 5 µm to 25 µm. In this way, both the production cost and the energy density of the perovskite battery can be considered.

In a possible implementation, the connection structure is a conductive structure that extends from a second surface of the second electrode layer to the first electrode layer, and the second surface of the second electrode layer is a surface of the second electrode layer close to the first electrode layer. In this way, it is convenient to prepare the connection structure, and thus conducive to reducing the complexity of the process and reducing the production cost.

In a possible implementation, the battery unit further includes a light absorption layer located between the first electrode layer and the second electrode layer. In this way, in addition to the first perovskite layer, an other light absorption layer is further disposed in the perovskite battery, which is conducive to further improving the efficiency of the perovskite battery.

In a possible implementation, the light absorption layer includes a second perovskite layer, a third electrode layer, a third charge transport layer, the second perovskite layer and a fourth charge transport layer that are located between the second charge transport layer and the second electrode layer and sequentially disposed. The low-dimensional perovskite layers are disposed on regions on the two sides of the connection structure opposite to the second perovskite layers. In this way, the perovskite battery has a stacked structure, and thus can have higher efficiency. Additionally, the disposing of the low-dimensional perovskite layers is conducive to further improving the efficiency and life of the perovskite battery.

In a possible implementation, the low-dimensional perovskite layers are disposed on regions on the two sides of the first isolation structure opposite to the second perovskite layers. In this way, regions of the second perovskite layers corresponding to the first isolation structure can be avoided from exposure, such that corrosion of the second perovskite layers by water and oxygen can be reduced, which is conducive to improving the life of the perovskite battery.

In a possible implementation, a band gap of the first perovskite layer is greater than that of the second perovskite layer. In this way, it is conducive to improving absorption efficiency of sunlight, and thus conducive to improving optical-to-electrical conversion efficiency.

In a possible implementation, the light absorption layer includes a copper indium gallium selenide layer. The battery unit further includes a fifth charge transport layer, the copper indium gallium selenide layer, a sixth charge transport layer and a fourth electrode layer that are located between the first electrode layer and the second charge transport layer and sequentially disposed. In this way, in the perovskite battery including the other type of light absorption layer, the disposing of the low-dimensional perovskite layers can improve the efficiency and life of the perovskite battery.

In a possible implementation, the low-dimensional perovskite layers have a thickness of 1 nm to 100 nm, and optionally, 1 nm to 4 nm. In this way, both a protection effect of the low-dimensional perovskite layers on the first perovskite layers and the connection structure and the efficiency and production cost of the perovskite battery can be considered.

In a possible implementation, the low-dimensional perovskite layers are one-dimensional perovskite layers. In this way, higher battery efficiency and life can be realized.

In a possible implementation, the second electrode layer and the connection structure are of a one-piece molded structure. In this way, preparation of the second electrode layer and the connection structure can be completed through sequential process steps, which is conducive to reducing the production cost.

In a possible implementation, a material of the first electrode layer includes at least one of indium tin oxide, indium zinc oxide, tungsten-doped indium oxide, gallium-doped zinc oxide, aluminum zinc oxide or fluorine-doped tin oxide. In this way, it can be ensured that the first electrode layer has good light transmittance and electrical conductivity.

In a possible implementation, a material of the second electrode layer includes at least one of indium tin oxide, indium zinc oxide, tungsten-doped indium oxide, gallium-doped zinc oxide, aluminum zinc oxide, Au, Ag, Cu, Al, Ni, Cr, Bi, Pt, Mg, Mo, W or alloy thereof, and a carbon material. Optionally, the carbon material includes at least one of carbon black, graphene or a carbon nanotube. In this way, it can be ensured that the second electrode layer has good electrical conductivity.

In a possible implementation, the first electrode layer has a thickness of 300 nm to 800 nm, the second electrode layer has a thickness of 10 nm to 200 nm, and the first perovskite layer has a thickness of 300 nm to 800 nm; and optionally, the first electrode layer has a thickness of 400 nm to 600 nm, the second electrode layer has a thickness of 80 nm to 120 nm, and the first perovskite layer has a thickness of 400 nm to 600 nm. In this way, both the efficiency and energy density of the perovskite battery can be considered.

In a possible implementation, the first perovskite layer has a structural formula of ABX₃. A has an ionic radius of 0.076 nm to 0.315 nm. B has an ionic radius of 0.06 nm to 0.15 nm. X has an ionic radius of 0.1 nm to 0.2 nm. Optionally, A includes at least one of an organic amine cation, Cs, K, Rb or Li, B includes at least one of lead, tin, zinc, titanium, antimony, bismuth, nickel, iron, cobalt, silver, copper, gallium, germanium, magnesium, calcium, indium, aluminum, manganese, chromium, molybdenum or europium, and X includes at least one of fluorine, chlorine, bromine or iodine. Optionally, the organic amine cation includes at least one of a methylamine ion or a formamidine ion. In this way, a perovskite of the first perovskite layer is of a three-dimensional structure, which is conducive to ensuring the efficiency of the perovskite battery.

In a possible implementation, the first charge transport layer is a hole transport layer, and the second charge transport layer is an electron transport layer. Or the first charge transport layer is the electron transport layer, and the second charge transport layer is the hole transport layer. In this way, it is convenient to flexibly dispose the first charge transport layer and the second charge transport layer according to actual needs.

In a possible implementation, a material of the hole transport layer includes a P-type semiconductor, and a material of the electron transport layer includes an N-type semiconductor. Optionally, the material of the hole transport layer includes at least one of thiophene, phthalocyanine, porphyrin, Spiro-OMeTAD, molybdenum oxide, vanadium pentoxide, tungsten oxide, nickel oxide, copper oxide, tin oxide, molybdenum disulfide, tungsten sulfide, copper sulfide, tin sulfide, cuprous thiocyanate, cuprous iodide, fluoro-containing phosphonic acid, carbonyl-containing phosphonic acid, a carbon nanotube or graphene. Optionally, the material of the electron transport layer includes at least one of [6,6]-phenyl-C₆₁-methyl isobutyrate, C₆₀, cyano-containing polyphenylacetylene, a boracic polymer, bathocuproine, bathophenanthroline, hydroxyquinoline aluminum, an oxadiazole compound, a benzimidazole compound, a naphthalene tetracarboxylic acid compound, a perylene derivative, a phosphine oxide compound, a phosphine sulfide compound, fluoro-containing phthalocyanine, titanium oxide, zinc oxide, indium oxide, tin oxide, gallium oxide, tin sulfide, indium sulfide, lithium fluoride, sodium fluoride, magnesium fluoride or zinc sulfide. In this way, it is convenient to flexibly select the materials of the first charge transport layer and the second charge transport layer according to actual needs.

In a possible implementation, the first charge transport layer has a thickness of 10 nm to 200 nm, and the second charge transport layer has a thickness of 10 nm to 200 nm. In this way, it is conducive to ensuring the efficiency of the perovskite battery.

In a possible implementation, a material of the substrate includes at least one of glass or a transparent flexible polymer. Optionally, the transparent flexible polymer includes at least one of polyethylene terephthalate or polyimide. In this way, it is convenient to flexibly select the material of the substrate according to actual needs.

According to a second aspect, the present application provides an electrical device, including the perovskite battery in the first aspect and in any one of the possible implementations. The perovskite battery is configured to supply power to the electrical apparatus.

According to a third aspect, the present application provides a method for preparing a perovskite battery, including: providing a plurality of battery units arranged along a first direction, each battery unit including a first electrode layer, a second electrode layer, and a first perovskite layer between the first electrode layer and the second electrode layer that are arranged along a second direction; and providing a connection structure that is configured to connect a first electrode layer of a first battery unit to a second electrode layer of a second battery unit that are adjacent among the plurality of battery units, where low-dimensional perovskite layers are disposed on regions on two sides of the connection structure opposite to the first perovskite layers. The perovskite battery prepared through the method has relatively high efficiency and life.

In a possible implementation, the providing a plurality of battery units arranged along a first direction includes: providing a substrate, the first electrode layer being disposed on the substrate; sequentially depositing a first charge transport layer, a first perovskite layer and a second charge transport layer on the first electrode layer; depositing a second electrode layer on the second charge transport layer; the providing a connection structure includes: etching the second charge transport layer along the second direction to expose the first electrode layer, thus forming a first etched bath; covering a solution containing low-dimensional perovskite cations on two opposite surfaces of the first etched bath along the first direction to prepare the low-dimensional perovskite layers between the connection structure and the first perovskite layers. The method facilitates the preparation of the low-dimensional perovskite layers, and thus is conducive to reducing the complexity of the process.

In a possible implementation, the method further includes: providing a first isolation structure, where the low-dimensional perovskite layers are disposed on regions on two sides of the first isolation structure opposite to the first perovskite layers; the providing a first isolation structure includes: etching the second electrode layer along the second direction to expose the first electrode layer, thus forming a second etched bath; and covering a solution containing low-dimensional perovskite cations on two opposite surfaces of the second etched bath along the first direction to prepare the low-dimensional perovskite layers between the first isolation structure and the first perovskite layers. The perovskite battery prepared through the method has higher efficiency and life.

An embodiment of the present application provides the perovskite battery, including the plurality of battery units arranged along the first direction and the connection structure. Each battery unit includes the first electrode layer, the second electrode layer, and the first perovskite layer between the first electrode layer and the second electrode layer that are arranged along the second direction. In this way, the battery unit can output the power through the first electrode layer and the second electrode layer and absorb sunlight through the first perovskite layer. The connection structure is configured to connect the first electrode layer of the first battery unit to the second electrode layer of the second battery unit that are adjacent among the plurality of battery units, such that the adjacent first battery unit and second battery unit can be electrically connected. Along the first direction, the low-dimensional perovskite layers are disposed on the regions on the two sides of the connection structure opposite to the first perovskite layers. On the one hand, the halogens in the low-dimensional perovskite layers are not prone to migration and thus not prone to reacting with the connection structure, which can reduce the corrosion of the connection structure caused by reacting of the low-dimensional perovskite layers with the connection structure, and thus is conducive to reducing the reduction in efficiency of the perovskite battery caused by the corrosion of the connection structure. Additionally, the first perovskite layers are not in contact with the connection structure, which can reduce the decomposition of the positions of the first perovskite layers corresponding to the connection structure, and thus is conducive to improving the life of the perovskite battery. On the other hand, the low-dimensional perovskite layers have the relatively low electron mobility and hole mobility, which can reduce the recombination of the leakage current and the carriers in the contact parts of the connection structure and the low-dimensional perovskite layers, and thus improve the efficiency of the perovskite battery. Therefore, the embodiment of the present application can improve the performance of the perovskite battery.

### BRIEF DESCRIPTION OF DRAWINGS

FIG. 1 is a schematic diagram of a perovskite battery according to an embodiment of the present application;
FIG. 2 is a schematic diagram of a perovskite battery according to an embodiment of the present application;
FIG. 3 is a schematic diagram of a perovskite battery according to an embodiment of the present application;
FIG. 4 is a schematic diagram of a perovskite battery according to an embodiment of the present application;
FIG. 5 is a schematic diagram of a perovskite battery according to an embodiment of the present application;
FIG. 6 is a schematic diagram of a battery unit of a perovskite battery according to an embodiment of the present application;
FIG. 7 is a schematic diagram of an electrical device of an embodiment of the present application;
FIG. 8 is a schematic diagram of a method for preparing a perovskite battery according to an embodiment of the present application.

### DETAILED DESCRIPTION OF EMBODIMENTS

Embodiments in which a negative electrode plate, a secondary battery, a battery module, a battery pack and an electrical device of the present application are specifically disclosed will be described in detail below with due reference to the accompanying drawings. However, unnecessary details may be omitted in some cases. For example, a detailed description of a well-known matter or repeated description of a substantially identical structure may be omitted. That is intended to prevent the following descriptions from becoming unnecessarily lengthy, and to facilitate understanding by a person skilled in the art. In addition, the accompanying drawings and the following description are intended for a person skilled in the art to fully understand the present application, but are not intended to limit the subject matter set forth in the claims.

"Range" disclosed in the present application is limited in the form of lower limit and upper limit, and given range is limited by selecting a lower limit and an upper limit, and the selected lower limit and upper limit define the boundary of a special range. The range limited in this way may include end values or not include end values, and may be combined arbitrarily, that is, any lower limit may be combined with any upper limit to form a range. For example, if the range of 60 to 120 and 80 to 110 is listed for a particular parameter, it is understood that the range of 60 to 110 and 80 to 120 is also expected. In addition, if the minimum range value 1 and 2 are listed, and if the maximum range value 3, 4 and 5 are listed, then the following ranges can be all expected: 1 to 3, 1 to 4, 1 to 5, 2 to 3, 2 to 4 and 2 to 5. In the present application, unless otherwise specified, numerical range "a to b" represents the abbreviation of any real number combination between a and b, where a and b are all real numbers. For example, the numerical range "0 to 5" means that all real numbers between "0 to 5" are listed in this disclosure, and "0 to 5" is just an abbreviation of these numerical combinations. In addition, when a parameter is expressed as an integer ≥ 2, it is equivalent to disclosing that the parameter is, for example, an integer 2, 3, 4, 5, 6, 7, 8, 9, 10, 11, 12, etc.

Unless otherwise expressly specified herein, any embodiments and optional embodiments hereof may be combined with each other to form a new technical solution.

Unless otherwise expressly specified herein, any technical features and optional technical features hereof may be combined with each other to form a new technical solution.

Unless otherwise expressly specified herein, all steps hereof may be performed sequentially or randomly, preferably sequentially. For example, the method includes steps (a) and (b), indicating that the method may include steps (a) and (b) performed sequentially, or may include steps (b) and (a) performed sequentially. For example, the method may further include step (c), indicating that step (c) may be added to the method in any order, for example, the method may include steps (a), (b) and (c), or may include steps (a), (c) and (b), or may include steps (c), (a) and (b), etc.

Unless otherwise expressly specified, "include" and "include" mentioned herein mean open-ended inclusion, or closed-ended inclusion. For example, the terms "include" and "include" may mean inclusion of other items that are not recited, or inclusion of only the items recited.

Unless otherwise expressly specified, the term "or" used herein is inclusive. For example, the phrase "A or B" means "A alone, B alone, or both A and B". More specifically, all and any of the following conditions satisfy the condition "A or B": A is true (or existent) and B is false (or absent); A is false (or absent) and B is true (or existent); and, both A and B are true (or existent).

Solar batteries, also known as photovoltaic batteries, are an apparatus that directly converts optical energy into electrical energy through a photoelectric effect or a photochemical effect. Perovskite batteries are a new type of solar batteries that has been extensively researched currently. In a few years since its inception, the perovskite batteries have soon achieved relatively high optical-to-electrical conversion efficiency, and enjoy a good application prospect. The perovskite battery includes a plurality of battery units and a connection structure. The connection structure realizes electrical connection between adjacent battery units by connecting a first electrode layer and a second electrode layer of the adjacent battery units.

The connection structure is usually made of a metal material. The metallic connection structure is in contact with a perovskite layer in the perovskite battery and reacts, resulting in corrosion of the connection structure. On the one hand, the corrosion of the connection structure leads to an increase in internal resistance of the perovskite battery, which is not conducive to improving the efficiency of the battery; and on the other hand, the perovskite layer is decomposed, which leads to a reduction in life of the perovskite battery.

In view of this, the present application provides a perovskite battery. In the perovskite battery, a low-dimensional perovskite layer is disposed between the perovskite layer and the connection structure, which is conducive to reducing risks of the corrosion of the connection structure and the decomposition of the perovskite layer, and thus conducive to improving performance of the perovskite battery.

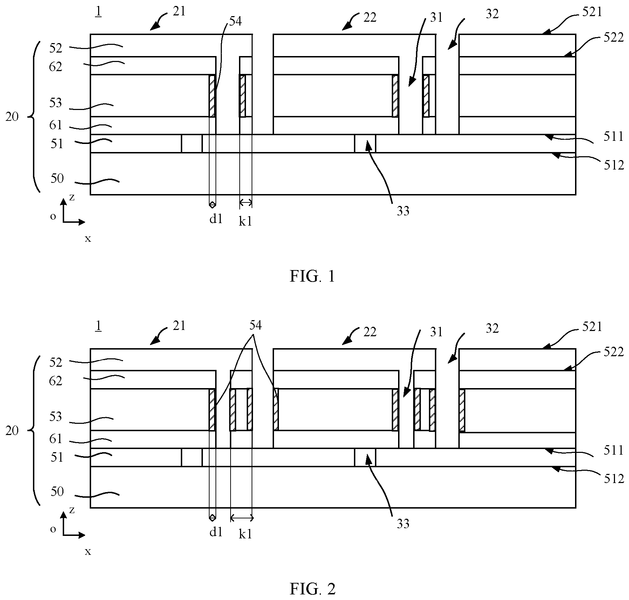

FIG. 1 is a schematic diagram of a perovskite battery according to an embodiment of the present application. As shown in FIG. 1, the perovskite battery 1 includes a plurality of battery units 20 arranged along a first direction and a connection structure 31.

The first direction is an arrangement direction of the plurality of battery units 20, for example, an x direction in FIG. 1.

Each battery unit 20 includes a first electrode layer 51, a second electrode layer 52, and a first perovskite layer 53 between the first electrode layer 51 and the second electrode layer 52 that are arranged along a second direction. Optionally, the second direction is perpendicular to the first direction, and is a z direction in FIG. 1, for example.

The first electrode layer 51 and the second electrode layer 52 are configured to output power of the perovskite battery 1. Materials of the first electrode layer 51 and the second electrode layer 52 may be set according to actual needs, as long as the power can be output.

The first perovskite layer 53 is a light absorption layer. The first perovskite layer 53 may generate an electron-hole pair when irradiated by sunlight.

The connection structure 31 is configured to connect a first electrode layer 51 of a first battery unit 21 to a second electrode layer 52 of a second battery unit 22 that are adjacent among the plurality of battery units 20. In other words, the plurality of battery units 20 include the adjacent first battery unit 21 and second battery unit 22, and the first electrode layer 51 of the first battery unit 21 and the second electrode layer 52 of the second battery unit 22 are connected through the connection structure 31. The connection structure 31 is a conductive structure. The adjacent battery units 20 are connected in series through the connection structure 31.

Optionally, the connection structure 31 and the second electrode layer 52 are made of a same material. For example, both the connection structure 31 and the second electrode layer 52 are made of a metal material.

Low-dimensional perovskite layers 54 are disposed on regions on two sides of the connection structure 31 opposite to the first perovskite layers 53.

Optionally, along the first direction, in a case that the first perovskite layer 53 is only disposed on one side of the connection structure 31, the low-dimensional perovskite layer 54 may only be disposed on a region on the side opposite to the first perovskite layer 53.

The first perovskite layer 53 and the low-dimensional perovskite layer 54 have different structures. The first perovskite layer 53 is a perovskite layer that is prepared from a three-dimensional perovskite. The low-dimensional perovskite layer 54 is a perovskite layer that is prepared from a non-three-dimensional perovskite. For example, the perovskite in the low-dimensional perovskite layer 54 is of a quasi-two-dimensional structure, a two-dimensional structure, a one-dimensional structure or a zero-dimensional structure. The dimension of the perovskite in the low-dimensional perovskite layer 54 may be determined through an X-ray diffractometer.

The low-dimensional perovskite layer 54 is more stable than the first perovskite layer 53. Halogens of the low-dimensional perovskite in the low-dimensional perovskite layer 54 are not prone to migration and thus not prone to reacting with the connection structure 31. By disposing the low-dimensional perovskite layers 54 on the regions on the two sides in the first direction of the connection structure 31 opposite to the first perovskite layers 53, the corrosion of the connection structure 31 can be reduced, such that it is conducive to reducing an increase in internal resistance of the perovskite battery 1 caused by the corrosion of the connection structure 31 and thus conducive to improving the efficiency of the perovskite battery 1. Additionally, the first perovskite layers 53 are not in contact with the connection structure 31, which can reduce the decomposition of the first perovskite layers 53 and thus is conducive to improving the life of the perovskite battery 1.

Both the electron mobility and the hole mobility of the low-dimensional perovskite layers 54 are lower than those of the first perovskite layers 53. By disposing the low-dimensional perovskite layers 54, recombination of a leakage current and carriers in contact parts of the connection structure 31 and the low-dimensional perovskite layers 54 can be reduced, which is conducive to improving the efficiency of the perovskite battery 1.

An embodiment of the present application provides the perovskite battery 1, including the plurality of battery units 20 arranged along the first direction and the connection structure 31. Each battery unit 20 includes the first electrode layer 51, the second electrode layer 52, and the first perovskite layer 53 between the first electrode layer 51 and the second electrode layer 52 that are arranged along the second direction. In this way, the battery unit 20 can output power through the first electrode layer 51 and the second electrode layer 52 and absorb sunlight through the first perovskite layer 53. The connection structure 31 is configured to connect the first electrode layer 51 of the first battery unit 21 to the second electrode layer 52 of the second battery unit 22 that are adjacent among the plurality of battery units 20, such that the adjacent first battery unit 21 and second battery unit 22 can be electrically connected. Along the first direction, the low-dimensional perovskite layers 54 are disposed on the regions on the two sides of the connection structure 31 opposite to the first perovskite layers 53. On the one hand, halogens in the low-dimensional perovskite layers 54 are not prone to migration and thus not prone to reacting with the connection structure 31, which can reduce corrosion of the connection structure 31 caused by reacting of the low-dimensional perovskite layers 54 with the connection structure 31, and thus is conducive to reducing the reduction in efficiency of the perovskite battery 1 caused by the corrosion of the connection structure 31. Additionally, the first perovskite layers 53 are not in contact with the connection structure 31, which can reduce decomposition of positions of the first perovskite layers 53 corresponding to the connection structure 31, and thus is conducive to improving the life of the perovskite battery 1. On the other hand, the low-dimensional perovskite layers 54 have relatively low electron mobility and hole mobility, which can reduce recombination of a leakage current and carriers in contact parts of the connection structure 31 and the low-dimensional perovskite layers 54, and thus improve the efficiency of the perovskite battery 1. Therefore, the embodiment of the present application can improve the performance of the perovskite battery 1.

In some embodiments, the low-dimensional perovskite layers 54 have a structural formula of (NH³⁺-R-NH³⁺)Aₙ₋₁BₙX₃ₙ₊₁ or (R-NH³⁺)₂Aₙ₋₁BₙX₃ₙ₊₁, and n ≤ 5. n is a positive integer. For example, n is 5, 4, 3, 2 and 1.

Optionally, a value of n may be determined through the X-ray diffractometer or a transmission electron microscope.

Combined with a structure of the low-dimensional perovskites, n may represent the number of inorganic layers between adj acent organic layers in the low-dimensional perovskites. R includes at least one of phenyl, aryl, alkyl or a piperidine derivative.

A includes at least one of Cs, FA, MA, Rb or K. B includes at least one of Pb²⁺ or Sn²⁺. X includes at least one of F⁻, Cl⁻, Br⁻ or I⁻.

In a case that n is greater than 5, the preparation difficulty of the low-dimensional perovskite layers 54 is increased, which is not conducive to preparing the low-dimensional perovskite layers 54 and reducing the production cost.

By setting n to be less than or equal to 5, it is convenient to prepare the low-dimensional perovskite layers 54, and in addition, the perovskite battery 1 has relatively high efficiency and life. For example, the efficiency of the perovskite battery may be improved to 15.7% or above, and the efficiency retention rate after 1000 h of storage may approach or even exceed 80%.

In some embodiments, the perovskite battery 1 further includes a first isolation structure 32. The first isolation structure 32 is configured to isolate a second electrode layer 52 of the first battery unit 21 from the second electrode layer 52 of the second battery unit 22. The first isolation structure 32 is spaced apart from the connection structure 31.

In these embodiments, the second electrode layers 52 of the adjacent battery units 20 are isolated through the first isolation structure 32. Additionally, spacing the first isolation structure 32 apart from the connection structure 31 is conducive to reducing complexity of a process and reducing the production cost.

In some embodiments, the battery unit 20 includes the first electrode layer 51, a first charge transport layer 61, the first perovskite layer 53, a second charge transport layer 62 and the second electrode layer 52 that are sequentially disposed on a substrate 50.

The first charge transport layer 61 and the second charge transport layer 62 are configured to transport carriers, e.g., to transport electrons or holes.

In these embodiments, by disposing the first charge transport layer 61 and the second charge transport layer 62, the carriers in the perovskite battery 1 can be transported.

In some embodiments, the first isolation structure 32 is an insulation structure that extends from a first surface 521 of the second electrode layer 52 to at least the first charge transport layer 62, and the first surface 521 of the second electrode layer 52 is a surface of the second electrode layer 52 away from the first electrode layer 51.

Optionally, along the second direction, the first isolation structure 32 extends from the first surface 521 of the second electrode layer 52 to a surface of the first charge transport layer 62 away from the second electrode layer 52. Optionally, along the second direction, the first isolation structure 32 extends from the first surface 521 of the second electrode layer 52 to a surface of the first charge transport layer 62 close to the second electrode layer 52.

Optionally, along the second direction, the first isolation structure 32 is an etched bath penetrating from the first surface 521 of the second electrode layer 52 to the surface of the first charge transport layer 62 away from the second electrode layer 52. Optionally, the etched bath is filled with an insulation material, thereby forming an insulation wall, which serves as the first isolation structure 32.

Along the second direction, the second electrode layer 52 includes two opposite surfaces. The first surface 521 of the second electrode layer 52 is away from the first electrode layer 51 relative to a second surface 522 of the second electrode layer 52.

FIG. 2 is a schematic diagram of a perovskite battery according to an embodiment of the present application. As shown in FIG. 2, along the first direction, low-dimensional perovskite layers 54 are disposed on regions on two sides of the first isolation structure 32 opposite to the first perovskite layers 53.

The low-dimensional perovskite layers 54 have better resistance to water and oxygen erosion, and by disposing the low-dimensional perovskite layers 54 on the regions on the two sides of the first isolation structure 32 opposite to the first perovskite layers 53, regions of the first perovskite layers 53 corresponding to the first isolation structure 32 can be avoided from exposure, such that corrosion of the first perovskite layers 53 by water and oxygen can be reduced, which is conducive to improving the life and efficiency of the perovskite battery 1.

In some embodiments, along the first direction, a distance k1 between the first isolation structure 32 and the connection structure 31 is 5 µm to 25 µm, and may be, for example, 5 µm, 15 µm, 20 µm and 25 µm.

The distance k1 between the connection structure 31 and the first isolation structure 32 is a minimum distance between the connection structure 31 and the first isolation structure 32, and the distance may be measured through an optical microscope.

In a case that k1 is less than 5 µm, along the first direction, the distance between the first isolation structure 32 and the connection structure 31 is overly small, resulting in an increase in process difficulty, which is not conducive to preparing the first isolation structure 32 and reducing the production cost.

In a case that k1 is greater than 25 µm, along the first direction, the distance between the first isolation structure 32 and the connection structure 31 is overly large, which is not conducive to increasing the energy density of the perovskite battery 1 and also not conducive to saving a production material.

In these embodiments, k1 is 5 µm to 25 µm. In this way, both the production cost and the energy density of the perovskite battery 1 can be considered.

In some embodiments, the connection structure 31 is a conductive structure that extends from the second surface 522 of the second electrode layer 52 to the first electrode layer 51 along the second direction, and the second surface 522 of the second electrode layer 52 is a surface of the second electrode layer 52 close to the first electrode layer 51.

For example, the connection structure 31 may be a conductive structure formed by filling a groove that extends from the second surface 522 of the second electrode layer 52 to the first electrode layer 51. A material of the connection structure 31 is the same as that of the second electrode layer 52. In other words, the connection structure 32 and the second electrode layer 52 are formed through a single deposition step.

Optionally, the connection structure 31 extends from the second surface 522 of the second electrode layer 52 to the first surface 511 of the first electrode layer 51 along the second direction, and the first surface 511 of the first electrode layer 51 is a surface of the first electrode layer 51 close to the second electrode layer 52.

Optionally, the connection structure 31 extends from the second surface 522 of the second electrode layer 52 to a second surface 512 of the first electrode layer 51 along the second direction, and the second surface 512 of the first electrode layer 51 is a surface of the first electrode layer 51 away from the second electrode layer 52.

In these embodiments, the connection structure 31 is a conductive structure that extends from the second surface 522 of the second electrode layer 52 to the first electrode layer 51 along the second direction. In this way, it is convenient to prepare the connection structure 31, and thus conducive to reducing the complexity of the process and reducing the production cost.

Optionally, the perovskite battery 1 further includes a second isolation structure 33. The second isolation structure 33 is configured to isolate the first electrode layer 51 of the first battery unit 21 from the first electrode layer 51 of the second battery unit 22 adjacent thereto. The size of the second isolation structure 33 along the second direction and the shape of the second isolation structure 33 are not particularly limited in these embodiments of the present application, as long as the first electrode layers 51 of the adjacent battery units 20 can be isolated.

For example, the second isolation structure 33 is an etched bath penetrating the first electrode layer 51. In other words, the second isolation structure 33 extends from the first surface 511 of the first electrode layer 51 to the second surface 512 of the first electrode layer 51 along the second direction. For another example, the second isolation structure 33 penetrates the first electrode layer 51 and the substrate 50 along the second direction. For another example, the second isolation structure 33 penetrates the first charge transport layer 61 and the first electrode layer 51 along the second direction. For another example, the second isolation structure 33 is an insulation wall that extends from the first surface 511 of the first electrode layer 51 to the second surface 512 of the first electrode layer 51 along the second direction, and the insulation wall is formed of an insulation material.

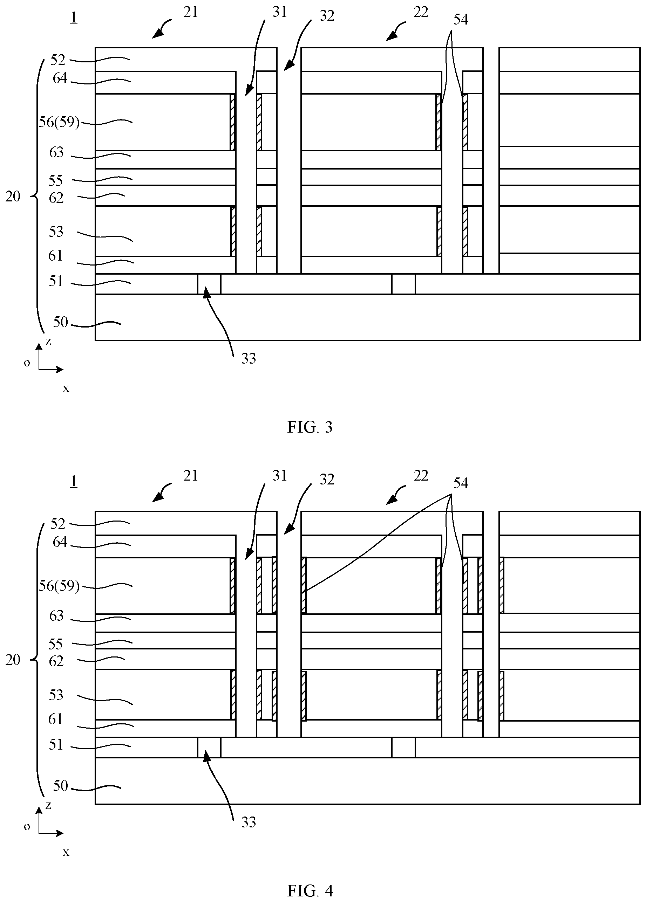

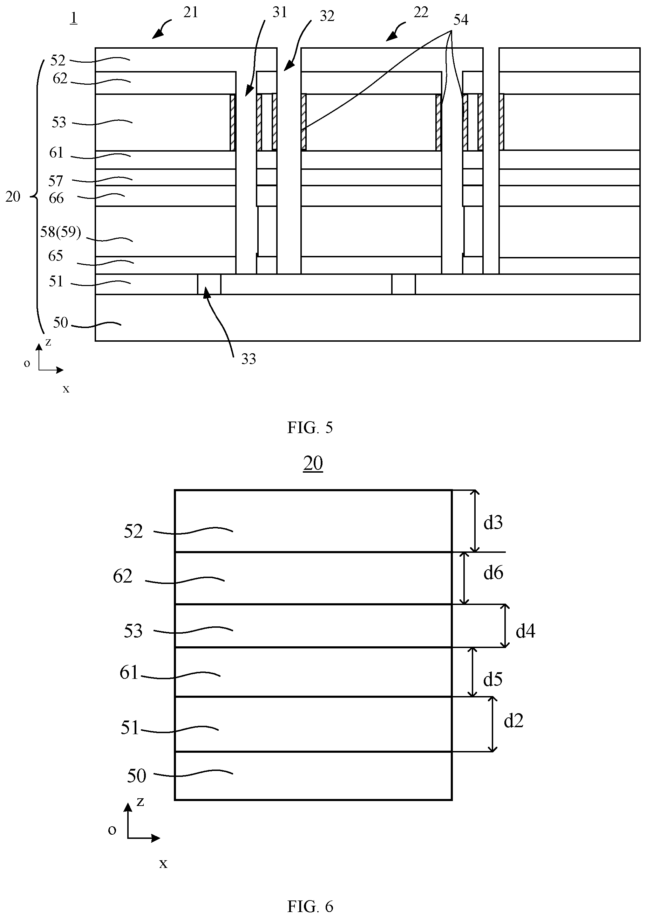

FIG. 3 is a schematic diagram of a perovskite battery according to an embodiment of the present application. FIG. 4 is a schematic diagram of a perovskite battery according to an embodiment of the present application. FIG. 5 is a schematic diagram of a perovskite battery according to an embodiment of the present application. As shown in FIG. 3 to FIG. 5, the battery unit 20 further includes a light absorption layer 59 located between the first electrode layer 51 and the second electrode layer 52.

In other words, the perovskite battery 1 includes the first perovskite layer 53 and the light absorption layer 59 in addition to the first perovskite layer 53. In this way, it is conducive to improving the efficiency of the perovskite battery 1.

In some embodiments, as shown in FIG. 3, the light absorption layer 59 includes a second perovskite layer 56. The battery cell 20 further includes a third electrode layer 55, a third charge transport layer 63, the second perovskite layer 56 and a fourth charge transport layer 64 that are located between the second charge transport layer 62 and the second electrode layer 52 and sequentially disposed. The low-dimensional perovskite layers 54 are disposed on regions on the two sides of the connection structure 31 opposite to the second perovskite layers 56.

The battery unit 20 shown in FIG. 3 may be known as a battery unit 20 of a stacked structure. The battery unit 20 shown in FIG. 3 includes two sub-batteries. One of the sub-batteries includes an electrode layer-charge transport layer-perovskite layer-charge transport layer-electrode layer structure. Optionally, the battery unit 20 may further include two or more sub-batteries, e.g., 3, 4 or more.

In these embodiments, the perovskite battery 1 has a stacked structure, and therefore may have higher efficiency. Additionally, the disposing of the low-dimensional perovskite layers 54 is conducive to further improving the efficiency and life of the perovskite battery 1.

In some embodiments, as shown in FIG. 4, along the first direction, the low-dimensional perovskite layers 54 are disposed on regions on the two sides of the first isolation structure 32 opposite to the second perovskite layers 56. In this way, regions of the second perovskite layers 56 corresponding to the first isolation structure 32 can be avoided from exposure, such that corrosion of the second perovskite layers 56 by water and oxygen can be reduced, which is conducive to improving the life and efficiency of the perovskite battery 1.

In some embodiments, a band gap of the first perovskite layer 53 is greater than that of the second perovskite layer 56. In this way, it is conducive to improving absorption efficiency of sunlight, and thus conducive to improving optical-to-electrical conversion efficiency.

The band gap may be measured through an ultraviolet-visible absorption spectrometer.

Optionally, the first perovskite layer 53 has a band gap of 1.7 eV to 1.9 eV, and the second perovskite layer 56 has a band gap of 0.8 eV to 1.2 eV.

Optionally, a material of the first perovskite layer 53 is Cs_{0.35}FA_{0.65}PbI_{1.8}Br_{1.2}, and a material of the second perovskite layer 56 is FA_{0.7}MA_{0.3}Pb_{0.5}Sn_{0.5}I₃.

In some embodiments, as shown in FIG. 5, the light absorption layer 59 includes a copper indium gallium selenide layer 58, and the battery unit 20 further includes a fifth charge transport layer 65, the copper indium gallium selenide layer 58, a sixth charge transport layer 66 and a fourth electrode layer 57 that are located between the first electrode layer 51 and the second charge transport layer 62 and sequentially disposed.

The perovskite battery 1 shown in FIG. 5 includes the copper indium gallium selenide layer 58 and the first perovskite layer 53. The perovskite battery 1 is of the stacked structure and has relatively high efficiency.

These embodiments provide the perovskite battery 1 including the other type of light absorption layer. The perovskite battery has the stacked structure and may have higher efficiency. Additionally, the disposing of the low-dimensional perovskite layers 54 can further improve the efficiency and life of the perovskite battery 1.

In some embodiments, the low-dimensional perovskite layers 54 have a thickness d1 of 1 nm to 100 nm, and optionally, 1 nm to 4 nm. For example, the low-dimensional perovskite layers 54 have a thickness d1 of 1 nm, 4 nm, 5 nm, 10 nm, 15 nm, 20 nm, 25 nm, 35 nm, 45 nm, 50 nm, 70 nm and 100 nm.

The thickness d1 of the low-dimensional perovskite layers 54 may be a maximum thickness of the low-dimensional perovskite layers 54.

In a case that the thickness d1 of the low-dimensional perovskite layers 54 is less than 1 nm, a protection effect on the first perovskite layer 53 and the connection structure 31 is relatively weak. In addition, the thickness d1 of the low-dimensional perovskite layers 54 is overly small, and thus the preparation difficulty is relatively high, which is not conducive to preparing the low-dimensional perovskite layers 54 and not conducive to reducing the production cost.

In a case that the thickness d1 of the low-dimensional perovskite layers 54 is greater than 100 nm, the efficiency of the perovskite battery 1 is less improved.

The thickness d1 of the low-dimensional perovskite layers 54 may be measured through a scanning tunneling electron microscope.

Optionally, along the first direction, sizes of the first perovskite layer 53 and the low-dimensional perovskite layers 54 are the same as those of the first charge transport layer 61 and the second charge transport layer 62. In other words, along the first direction, the low-dimensional perovskite layers 54 do not protrude from the first charge transport layer 61 and the second charge transport layer 62. When the thickness d1 of the low-dimensional perovskite layers 54 is overly large, the proportion of the first perovskite layer 53 is reduced, which is not conducive to improving the efficiency of the perovskite battery 1.

Optionally, the low-dimensional perovskite layers 54 have a thickness d1 of 1 nm to 4 nm. Superior battery efficiency and life can be realized at a relatively small thickness of the low-dimensional perovskite layers.

Optionally, the low-dimensional perovskite layers 54 have a thickness d1 of 20 nm to 50 nm. In this way, the efficiency of the perovskite battery may approach or even exceed 16%, and the efficiency retention rate after 1000 h of storage may approach or even exceed 90%.

Optionally, the thickness of the low-dimensional perovskite layers 54 on the two sides of the connection structure 31 may be different from those of the low-dimensional perovskite layers 54 on the two sides of the first isolation structure 32.

In these embodiments, the low-dimensional perovskite layers 54 have a thickness d1 of 1 nm to 100 nm. In this way, both the protection effect of the low-dimensional perovskite layers 54 on the first perovskite layer 53 and the connection structure 31 and the efficiency and production cost of the perovskite battery 1 can be considered.

In some embodiments, the low-dimensional perovskite layers 54 are one-dimensional perovskite layers. In this way, higher battery efficiency and life can be realized. For example, the efficiency of the perovskite battery 1 may reach 17.1%, and the efficiency retention rate after 1000 h of storage may reach 94%.

In some embodiments, the second electrode layer 52 and the connection structure 31 are of a one-piece molded structure. In other words, the second electrode layer 52 and the connection structure 31 are formed through a single process step. In this way, the preparation of the second electrode layer 52 and the connection structure 31 can be completed through the single process step, which is conducive to reducing the production cost.

Optionally, the connection structure 31 and the second conductive layer 52 are formed through the single deposition step.

Optionally, the first electrode layer 51 is a transparent conductive oxide.

In some embodiments, a material of the first electrode layer 51 includes at least one of indium tin oxide (ITO), indium zinc oxide (IZO), tungsten-doped indium oxide (IWO), gallium-doped zinc oxide (GZO), zinc aluminum oxide (AZO) or fluorine-doped tin oxide. In this way, it can be ensured that the first electrode layer 51 has good light transmittance and electrical conductivity.

In some embodiments, a material of the second electrode layer 52 includes at least one of indium tin oxide, indium zinc oxide, tungsten-doped indium oxide, gallium-doped zinc oxide, aluminum zinc oxide, Au, Ag, Cu, Al, Ni, Cr, Bi, Pt, Mg, Mo, W or alloy thereof, and a carbon material. Optionally, the carbon material includes at least one of carbon black, graphene or a carbon nanotube. In this way, it can be ensured that the second electrode layer 52 has good electrical conductivity.

FIG. 6 is a schematic diagram of a battery unit of a perovskite battery according to an embodiment of the present application. In some embodiments, as shown in FIG. 6, the first electrode layer 51 has a thickness d2 of 300 nm to 800 nm, the second electrode layer 52 has a thickness d3 of 10 nm to 200 nm, and the first perovskite layer 53 has a thickness d4 of 300 nm to 800 nm.

The thickness d2 of the first electrode layer 51, the thickness d3 of the second electrode layer 52 and the thickness d4 of the first perovskite layer 53 may be maximum thicknesses of the first electrode layer 51, the second electrode layer 52 and the first perovskite layer 53 respectively, and the thicknesses thereof may be measured through a step profiler.

In a case that the thickness d2 of the first electrode layer 51 is greater than 800 nm, the transmittance of the first electrode layer is reduced, which is not conducive to improving the efficiency of the perovskite battery 1. In a case that the thickness d2 of the first electrode layer 51 is less than 300 nm, the transmittance of the first electrode layer is relatively low, making it difficult to ensure the life and efficiency of the perovskite battery 1.

In a case that the thickness d3 of the second electrode layer 52 is greater than 200 nm, the perovskite battery 1 occupies a relatively large space, which is not conducive to increasing the energy density of the perovskite battery 1. In a case that the thickness d3 of the second electrode layer 52 is less than 10 nm, it is difficult to ensure the life and efficiency of the perovskite battery 1.

In a case that the thickness d4 of the first perovskite layer 53 is greater than 800 nm, the perovskite battery 1 occupies a relatively large space, which is not conducive to increasing the energy density of the perovskite battery 1. In a case that the thickness d4 of the first perovskite layer 53 is less than 300 nm, the first perovskite layer 53 is relatively thin and cannot completely absorb incident light, which is not conducive to improving the battery efficiency.

In these embodiments, by reasonably setting the thickness d2 of the first electrode layer 51, the thickness d3 of the second electrode layer 52 and the thickness d4 of the first perovskite layer 53, both the efficiency and the energy density of the perovskite battery 1 can be considered.

Optionally, the first electrode layer 51 has a thickness d2 of 400 nm to 600 nm, the second electrode layer 52 has a thickness d3 of 80 nm to 120 nm, and the first perovskite layer 53 has a thickness d4 of 400 nm to 600 nm. In this way, it is conducive to further achieving both the efficiency and the energy density of the perovskite battery 1.

In some embodiments, the first perovskite layer has a structural formula of ABX₃. A has an ionic radius of 0.076 nm to 0.315 nm. B has an ionic radius of 0.06 nm to 0.15 nm. X has an ionic radius of 0.1 nm to 0.2 nm. Optionally, A includes at least one of an organic amine cation, Cs, K, Rb or Li, B includes at least one of lead, tin, zinc, titanium, antimony, bismuth, nickel, iron, cobalt, silver, copper, gallium, germanium, magnesium, calcium, indium, aluminum, manganese, chromium, molybdenum or europium, and X includes at least one of fluorine, chlorine, bromine or iodine. Optionally, the organic amine cation includes at least one of a methylamine ion or a formamidine ion.

The first perovskite layer 53 is prepared from a perovskite. In other words, the structural formula of the first perovskite layer 53 is a structural formula of the perovskite for preparing the first perovskite layer 53.

In these embodiments, by selecting the perovskite of the above structural formula as a material of the first perovskite layer 53, the efficiency of the perovskite battery 1 can be ensured.

In some embodiments, the first charge transport layer 61 is a hole transport layer, and the second charge transport layer 62 is an electron transport layer. Or the first charge transport layer 61 is the electron transport layer, and the second charge transport layer 62 is the hole transport layer. In this way, it is convenient to flexibly dispose the first charge transport layer 61 and the second charge transport layer 62 according to actual needs.

The battery unit 20 may be a forward structure system, and may also be a reverse structure system.

For example, with reference to FIG. 4 and FIG. 5, when the battery unit 20 is the forward structure system, the first charge transport layer 61 is the hole transport layer, the second charge transport layer 62 is the electron transport layer, the third charge transport layer 63 is the hole transport layer, and the fourth charge transport layer 64 is the electron transport layer. When the battery unit 20 is the reverse structure system, the first charge transport layer 61 is the electron transport layer, the second charge transport layer 62 is the hole transport layer, the third charge transport layer 63 is the electron transport layer, and the fourth charge transport layer 64 is the hole transport layer.

In some embodiments, a material of the hole transport layer includes a P-type semiconductor, and a material of the electron transport layer includes an N-type semiconductor. Optionally, the material of the hole transport layer includes at least one of thiophene, phthalocyanine, porphyrin, Spiro-OMeTAD, molybdenum oxide, vanadium pentoxide, tungsten oxide, nickel oxide, copper oxide, tin oxide, molybdenum disulfide, tungsten sulfide, copper sulfide, tin sulfide, cuprous thiocyanate, cuprous iodide, fluoro-containing phosphonic acid, carbonyl-containing phosphonic acid, a carbon nanotube or graphene. Optionally, the material of the electron transport layer includes at least one of [6,6]-phenyl-C₆₁-methyl isobutyrate, C₆₀, cyano-containing polyphenylacetylene, a boracic polymer, bathocuproine, bathophenanthroline, hydroxyquinoline aluminum, an oxadiazole compound, a benzimidazole compound, a naphthalene tetracarboxylic acid compound, a perylene derivative, a phosphine oxide compound, a phosphine sulfide compound, fluoro-containing phthalocyanine, titanium oxide, zinc oxide, indium oxide, tin oxide, gallium oxide, tin sulfide, indium sulfide, lithium fluoride, sodium fluoride, magnesium fluoride or zinc sulfide. In this way, it is convenient to flexibly select the materials of the first charge transport layer 61 and the second charge transport layer 62 according to actual needs.

In some embodiments, the first charge transport layer 61 has a thickness d5 of 10 nm to 200 nm, and the second charge transport layer 62 has a thickness d6 of 10 nm to 200 nm. In this way, it is conducive to ensuring the efficiency of the perovskite battery 1.

The thickness d5 of the first charge transport layer 61 or the thickness d6 of the second charge transport layer 62 may be, for example, 10 nm, 15 nm, 20 nm, 25 nm, 30 nm, 50 nm, 60 nm, 80 nm, 100 nm, 120 nm, 150 nm, 180 nm and 200 nm.

Optionally, when a material of the first charge transport layer 61 is NiO, the thickness d5 of the first charge transport layer 61 usually does not exceed 50 nm. When the first charge transport layer 61 is prepared from other materials, the thickness of the first charge transport layer 61 may reach 200 nm. For example, the material of the first charge transport layer 61 is Spiro-OMeTAD.

In a case that the thickness d5 of the first charge transport layer 61 or the thickness d6 of the second charge transport layer 62 is greater than 200 nm, the perovskite battery 1 occupies a relatively large space, which is not conducive to increasing the energy density.

In a case that the thickness d5 of the first charge transport layer 61 or the thickness d6 of the second charge transport layer 62 is less than 10 nm, it is not conducive to ensuring performance of the first charge transport layer 61 or the second charge transport layer 62.

In some embodiments, a material of the substrate 50 includes at least one of glass or a transparent flexible polymer. Optionally, the transparent flexible polymer includes at least one of polyethylene terephthalate or polyimide. In this way, it is convenient to select the material of the substrate 50 according to actual needs, such as whether to prepare a jelly-roll perovskite battery.

The present application provides an electrical device, including the perovskite battery 1 according to any one of the foregoing embodiments. The perovskite battery 1 is configured to supply power to the electrical apparatus.

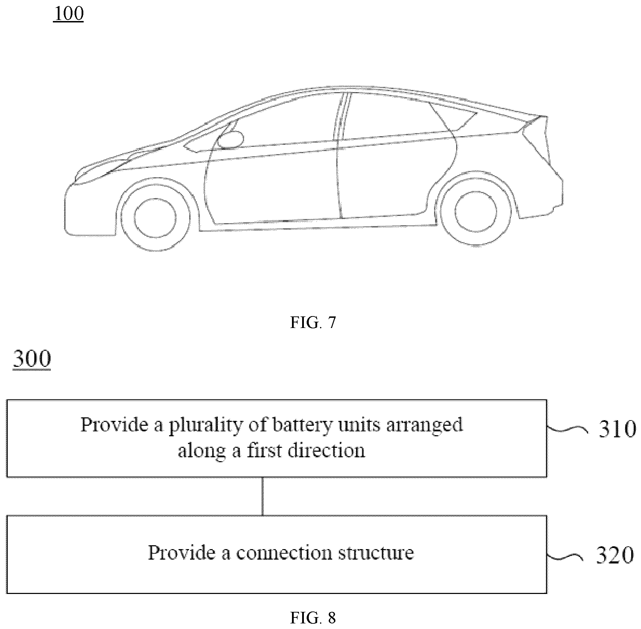

FIG. 7 is a schematic diagram of an electrical device of an embodiment of the present application. As shown in FIG. 7, the electrical apparatus is a vehicle 100. The perovskite battery 1 is disposed on the vehicle 100 and configured to supply power to the vehicle 100 or a storage battery in the vehicle 100.

Optionally, the electrical device may further be a street lamp, a power storage station or other devices.

The product embodiments of the present application for the perovskite battery 1 are described in detail above with reference to FIG. 1 to FIG. 7. The following will describe embodiments of the present application for a method for preparing the perovskite battery in detail. Understandably, for parts of the method embodiments corresponding to the product embodiments, similar descriptions may refer to the product embodiments.

FIG. 8 is a schematic diagram of a method for preparing a perovskite battery according to an embodiment of the present application. As shown in FIG. 8, the present application provides a method 300 for preparing a perovskite battery, including step 310 and step 320.

Step 310: providing a plurality of battery units 20 arranged along a first direction.

Each battery unit 20 includes a first electrode layer 51, a second electrode layer 52, and a first perovskite layer 53 between the first electrode layer 51 and the second electrode layer 52 that are arranged along a second direction.

Step 320: providing a connection structure 31.

The connection structure 31 is configured to connect a first electrode layer 51 of a first battery unit 21 to a second electrode layer 52 of a second battery unit 22 that are adjacent among the plurality of battery units 20, where low-dimensional perovskite layers 54 are disposed on regions on two sides of the connection structure 31 opposite to the first perovskite layers 53.

In this embodiment of the present application, the perovskite battery 1 prepared through the method 300 has relatively high efficiency and life.

In some embodiments, step 310 includes: providing a substrate 50, the first electrode layer 51 being disposed on the substrate 50; sequentially depositing a first charge transport layer 61, a first perovskite layer 53 and a second charge transport layer 62 on the first electrode layer 51; and depositing a second electrode layer 53 on the second charge transport layer 62.

Optionally, before the first charge transport layer 61 is deposited, the first electrode layer 51 is etched along the second direction to form a second isolation structure 33.

Step 320 includes: etching the second charge transport layer 62 along the second direction to expose the first electrode layer 51, thus forming a first etched bath; and covering a solution containing low-dimensional perovskite cations on two opposite surfaces of the first etched bath along the first direction to prepare the low-dimensional perovskite layers 54 between the connection structure 31 and the first perovskite layers 53.

The low-dimensional perovskite cations may react with the first perovskite layers 53 to form the low-dimensional perovskite layers 54.

A solvent in the solution containing the low-dimensional perovskite cations does not react with the first perovskite layers 53. The solvent may be anti-solvents such as ethyl ether and iso-propyl alcohol. Optionally, after a certain time, the excess solution or solvent is completely sucked out by vacuumizing.

Optionally, in the step of covering a solution containing low-dimensional perovskite cations on two opposite surfaces of the first etched bath along the first direction, the solution containing the low-dimensional perovskite cations may be covered inside the first etched bath by coating, spraying, soaking, or the like.

Optionally, before the second electrode layer 53 is deposited on the second charge transport layer 62, the second charge transport layer 62 is etched along the second direction to expose the first electrode layer 51, thus forming the first etched bath. After the first etched bath is formed, a corresponding material is deposited inside a second etched bath and on a surface of the second charge transport layer 62 to form the connection structure 31 and the second electrode layer 52. In the step, the connection structure 31 and the second electrode layer 52 are of the same material and formed through the single deposition step.

The method according to these embodiments facilitates preparation of the low-dimensional perovskite layers 54, and thus is conducive to reducing the complexity of the process.

In some embodiments, the method 300 further includes: providing a first isolation structure 32.

The low-dimensional perovskite layers 54 are disposed on regions on two sides of the first isolation structure 32 opposite to the first perovskite layers 53.

The providing a first isolation structure 32 includes: etching the second electrode layer 52 along the second direction to expose the first electrode layer 51, thus forming a second etched bath; and covering a solution containing low-dimensional perovskite cations on two opposite surfaces of the second etched bath along the first direction to prepare the low-dimensional perovskite layers 54 between the first isolation structure 32 and the first perovskite layers 53.

The perovskite battery prepared through the method according to these embodiments has higher efficiency and life.

### Embodiments

Hereinafter, the embodiments of the present application will be described. The embodiments described below are exemplary and are only used to explain the present application, and should not be construed as limiting the present application. If no specific technique or condition is indicated in the embodiments, the techniques or conditions described in the literature in this field or the product specifications are used. The reagents or instruments used that do not indicate the manufacturer are all conventional products that can be obtained commercially.

### Embodiment 1

A structure of Embodiment 1 may refer to FIG. 1. A preparation method of the perovskite battery 1 shown in Embodiment 1 is as follows.
(1) A fluorine-doped tin oxide (FTO) conductive glass sheet of 100 mm * 100 mm in size is taken. The FTO conductive glass is the substrate 50 provided with the first electrode layer 51.
(2) After being cleaned up, the FTO conductive glass is scribed by using nanosecond red light to form a P1 etched bath penetrating the first conductive layer 51 to prepare the second isolation structure 33.
(3) A nickel oxide layer with a thickness of 20 nm is prepared on the FTO conductive glass by using a magnetron sputtering method to form the first charge transport layer 61.
(4) The first charge transport layer 61 is coated with a 1 mol/L MAPbI₃ precursor solution, and then transferred into a vacuumizing device for vacuumizing for 60 s, with a vacuum pressure of 15 Pa. Then, after vacuumizing, the conductive glass with the first charge transport layer 61 prepared thereon is placed on a hotplate of 100°C for annealing for 40 min to obtain a MAPbI₃ perovskite layer with a thickness of about 500 nm to form the first perovskite layer 53.
(5) On the first perovskite layer 53, 25 nm C₆₀, 6 nm BCP and 20 nm Cu are evaporated by using an evaporation method to prepare the second charge transport layer 62. C₆₀ and BCP serve as the second charge transport layer 62, and Cu may be configured to protect the second charge transport layer 62 when the second electrode layer 52 is prepared.
(6) The conductive glass with the second charge transport layer 62 prepared thereon is scribed by using picosecond green light to from a P2 etched bath that penetrates from a surface of the second charge transport layer 62 away from the first electrode layer 51 to a surface of the first electrode layer 51 close to the second electrode layer 52 in the second direction.
(7) The substrate provided with the P2 etched bath is placed into an iso-propyl alcohol (IPA) solution with 0.05 mg/mL PEAI for 10 s, and after taking out, an excess solvent is completely sucked by using a vacuumizing method, where PEA is phenylethylamine.
(8) 100 nm Cu is evaporated inside the P2 etched bath and on the surface of the second charge transport layer 62 by using the evaporation method to prepare the connection structure 31 and the second electrode layer 52.
(9) The second electrode layer 52 is scribed by using the picosecond green light to expose the surface of the first electrode layer 51 close to the second electrode layer 52 to form a P3 etched bath. The P3 etched bath serves as the first isolation structure 32.

### Embodiment 2

Embodiment 2 differs from Embodiment 1 in that the low-dimensional perovskites in the low-dimensional perovskite layers 54 are different from those in Embodiment 1, and the low-dimensional perovskite layers in Embodiment 2 may be prepared by replacing PEAI in step (6) with BAI, where BA is butyl amine.

### Embodiment 3

Embodiment 3 differs from Embodiment 1 in that the low-dimensional perovskites in the low-dimensional perovskite layers 54 are different from those in Embodiment 1, and the low-dimensional perovskite layers in Embodiment 3 may be prepared by replacing PEAI in step (6) with PAI, where PA is propylamine.

### Embodiment 4

Embodiment 4 differs from Embodiment 1 in that the low-dimensional perovskites in the low-dimensional perovskite layers 54 are different from those in Embodiment 1, and the low-dimensional perovskite layers in Embodiment 4 may be prepared by replacing PEAI in step (6) with PDAI, where PDA is 1,3-propane diamine.

### Embodiments 5-10

Embodiments 5 to 10 differ from Embodiment 1 in that the low-dimensional perovskite layers 54 have a different thickness. The different thickness of the low-dimensional perovskite layers 54 may be realized by soaking in step (6) for a different time. Soaking times in Embodiments 5 to 7 are 1 s, 2 s, 3 s, 30 s, 45 s and 60 s respectively.

### Embodiment 11

A structure of Embodiment 11 may refer to FIG. 2. The perovskite battery corresponding to Embodiment 11 may be obtained by soaking the product obtained in step (9) into an IPA solution with 0.05 mg/mL PEAI for 10 s.

### Embodiments 12-13

Embodiments 12 to 13 differ from Embodiment 11 in that the low-dimensional perovskite layers on the two sides of the first isolation structure 32 have a different thickness. In Embodiments 12 and 13, the product obtained in step (9) is soaked in the IPA solution with 0.05 mg/mL PEAI for 1 s and 60 s respectively.

### Embodiment 14

A structure of Embodiment 14 may refer to FIG. 4. Embodiment 14 differs from Embodiment 11 in that the perovskite battery in Embodiment 14 is a perovskite battery of a stacked structure. In Embodiment 14, the substrate 50 is a glass substrate, the first electrode layer 51 is ITO, the first charge transport layer 61 is NiO, the first perovskite layer 53 is Cs_{0.35}FA_{0.65}PbI_{1.8}Br_{1.2}, the second charge transport layer 62 is C₆₀ and SnO₂, the third electrode layer 55 is Au, the third charge transport layer 63 is PEDOT: PSS, the second perovskite layer 56 is FA_{0.7}MA_{0.3}Pb_{0.5}Sn_{0.5}I₃, the material of the fourth charge transport layer 64 is C₆₀ and SnO₂, and the second electrode layer 52 is Ag.

### Embodiment 15

A structure of Embodiment 15 may refer to FIG. 5. Embodiment 15 differs from Embodiment 11 in that the perovskite battery in Embodiment 14 is a perovskite battery of a stacked structure. In Embodiment 15, the substrate 50 is a glass substrate, the first electrode layer 51 is Mo, the fifth charge transport layer 65 is PTAA, the light absorption layer 58 is CIGS, the sixth charge transport layer 66 is ZnO₂, the fourth electrode layer 57 is indium tin oxide, the first charge transport layer 61 is PTAA, the first perovskite layer 53 is Cs_{0.00}FA_{0.77}MA_{0.14}Pb(I_{0.36}Br_{0.14})₃, the second charge transport layer 62 is PCBM, and the second electrode layer 52 is indium tin oxide.

### Embodiment 16

Embodiment 16 differs from Embodiment 1 in that the low-dimensional perovskite layers have a different dimension. The low-dimensional perovskite layers in Embodiment 16 may be prepared by replacing PEAI in step (6) with C₄N₂H₁₄I.

### Embodiment 17

Embodiment 17 differs from Embodiment 1 in that the low-dimensional perovskite layers have a different dimension. The low-dimensional perovskite layers in Embodiment 17 may be prepared by replacing PEAI in step (6) with CsI.

### Embodiments 18-21

Embodiments 18 to 21 differ from Embodiment 1 in that n in the structural formula of the low-dimensional perovskite layers is 2, 3, 4, and 5. Different values of n may be obtained by controlling a temperature of the solution. Temperatures corresponding to 2, 3, 4, and 5 are 35°C, 45°C, 50°C and 55°C respectively.

In Embodiments 1 to 21, the first electrode layer 51 has a thickness of 500 nm, the second electrode layer 52 has a thickness of 100 nm, the first perovskite layer 53 has a thickness of 500 nm, the first charge transport layer 61 has a thickness of 20 nm, and the second charge transport layer 62 has a thickness of 31 nm.

### Embodiments 22-24

Embodiments 22 to 24 differ from Embodiment 11 in that a value of k1 is different. k1 is the distance between the first isolation structure 32 and the connection structure 31.

### Embodiments 25-30

Embodiments 25 to 30 differ from Embodiment 1 in the thickness of the first electrode layer 51, the thickness of the second electrode layer 52, the thickness of the first charge transport layer 61 and the thickness of the second charge transport layer 62.

### Comparative Embodiment 1

Comparative Embodiment 1 differs from Embodiment 2 in that in the perovskite battery 1, along the first direction, the low-dimensional perovskite layers 54 are not disposed on the regions on the two sides of the connection structure 31 opposite to the first perovskite layers.

### Comparative Embodiment 2

Comparative Embodiment 2 differs from Embodiment 11 in that in the perovskite battery 1, along the first direction, the low-dimensional perovskite layers 54 are not disposed on the regions on the two sides of the connection structure 31 opposite to the first perovskite layers.

An experiment is performed on the perovskite batteries prepared in the above embodiments and comparative embodiments to test the efficiency and lives of the batteries.

Method for testing the battery efficiency:
under a condition of a room temperature and less than 2% RH, the efficiency of the batteries is tested under irradiation of standard simulated sunlight (AM1.5G, 100 mW/cm²).

Method for testing the battery lives:
after 1000 h of storage under a condition of a dark state, 25°C and 50% to 60% RH, the efficiency of the batteries is tested under irradiation of the standard simulated sunlight (AM 1.5G, 100 mW/cm²). Efficiency retention rate = efficiency after 1000 h of storage/initial efficiency * 100%.

### Experimental results

Experimental results of different embodiments and comparative embodiments may refer to Table 1 and Table 2.

In Table 1 and Table 2, d1 is the thickness of the low-dimensional perovskite layers 54 opposite to the connection structure 31, d1' is the thickness of the low-dimensional perovskite layers 54 opposite to the first isolation structure 32, n is a value of n in a structural formula of the low-dimensional perovskites in the low-dimensional perovskite layers 54, and Dimension is the number of dimensions of the low-dimensional perovskites in the low-dimensional perovskite layers. 2D represents a two-dimensional perovskite, 1D represents a one-dimensional perovskite, and 0D represents a zero-dimensional perovskite. k1 is the distance between the first isolation structure 32 and the connection structure 31, d2 is the thickness of the first electrode layer 51, d3 is the thickness of the second electrode layer 52, d4 is the thickness of the first perovskite layer 53, d5 is the thickness of the first charge transport layer 61, and d6 is the thickness of the second charge transport layer 62.

**Table 1 Experimental results of Embodiments 1 to 24 and Comparative Embodiments 1 to 2**

| | Material of first perovskite layer | Material of low-dimensional perovskite layers opposite to connection structure | n | Dimensi on | k1/ µm | d1/ nm | Materia l of low-dimensi onal perovsk ite layers opposit e to first isolation structure | d1'/ nm | Battery efficienc y/% | Efficiency retention rate after 1000 h of storage/% |
|---|---|---|---|---|---|---|---|---|---|---|
| Embodi ment 1 | MAPbI₃ | PEA₂PbI₄ | 1 | 2D | 20 | 20 | / | / | 16.0% | 88% |
| Embodi ment 2 | MAPbI₃ | BA₂PbI₄ | 1 | 2D | 20 | 20 | / | / | 15.8% | 92% |
| Embodi ment 3 | MAPbI₃ | PA₂PbI₄ | 1 | 2D | 20 | 20 | / | / | 16.3% | 79% |
| Embodi ment 4 | MAPbI₃ | PDAPbI₄ | 1 | 2D | 20 | 20 | / | / | 17.0% | 84% |
| Embodi ment 5 | MAPbI₃ | PEA₂PbI₄ | 1 | 2D | 20 | 1 | / | / | 16.0% | 78% |
| Embodi ment 6 | MAPbI₃ | PEA₂PbI₄ | 1 | 2D | 20 | 2 | / | / | 15.9% | 88% |
| Embodi ment 7 | MAPbI₃ | PEA₂PbI₄ | 1 | 2D | 20 | 4 | / | / | 15.8% | 89% |
| Embodi ment 8 | MAPbI₃ | PEA₂PbI₄ | 1 | 2D | 20 | 50 | / | / | 16.0% | 90% |
| Embodi ment 9 | MAPbI₃ | PEA₂PbI₄ | 1 | 2D | 20 | 80 | / | / | 15.7% | 90% |
| Embodi ment 10 | MAPbI₃ | PEA₂PbI₄ | 1 | 2D | 20 | 100 | / | / | 15.5% | 90% |
| Embodi ment 11 | MAPbI₃ | PEA₂PbI₄ | 1 | 2D | 20 | 20 | PEA₂Pb I₄ | 20 | 16.0% | 91% |
| Embodi ment 12 | MAPbI₃ | PEA₂PbI₄ | 1 | 2D | 20 | 20 | PEA₂Pb I₄ | 1 | 16.0% | 90% |
| Embodi ment 13 | MAPbI₃ | PEA₂PbI₄ | 1 | 2D | 20 | 20 | PEA₂Pb I₄ | 100 | 15.7% | 92% |
| Embodi ment 14 | Cs_{0.35}FA_{0.65}Pb I_{1.8}Br_{1.2} | PEA₂PbI₄ | 1 | 2D | 20 | 20 | PEA₂Pb I₄ | 20 | 18% | 70% |
| Embodi ment 15 | Cs_{0.00}FA_{0.77}M A_{0.14}Pb(I_{0.86}Br _{0.14})₃ | PEA₂PbI₄ | 1 | 2D | 20 | 20 | PEA₂Pb I₄ | 20 | 19% | 80% |
| Embodi ment 16 | MAPbI₃ | C₄N₂H₁₄PbI₄ | 1 | 1D | 20 | 20 | / | / | 17.1% | 94% |
| Embodi ment 17 | MAPbI₃ | Cs4Pb16 | 1 | 0D | 20 | 20 | / | / | 16.2% | 89% |
| Embodi ment 18 | MAPbI₃ | PEA₂MAPb₂I₇ | 2 | 2D | 20 | 20 | / | / | 15.5% | 85% |
| Embodi ment 19 | MAPbI₃ | PEA₂MA₂Pb₃O₁₀ | 3 | 2D | 20 | 20 | / | / | 15.3% | 84% |
| Embodi ment 20 | MAPbI₃ | PEA₂MA₃Pb₄I₁₃ | 4 | 2D | 20 | 20 | | | 15.2% | 83% |
| Embodi ment 21 | MAPbI₃ | PEA₂MA₄Pb₅I₁₆ | 5 | 2D | 20 | 20 | / | / | 15% | 82% |
| Embodi ment 22 | MAPbI₃ | PEA₂PbI₄ | 1 | 2D | 5 | 20 | PEA₂Pb I₄ | 20 | 16.0% | 91% |
| Embodi ment 23 | MAPbI₃ | PEA₂PbI₄ | 1 | 2D | 15 | 20 | PEA₂Pb I₄ | 20 | 16.0% | 91% |
| Embodi ment 24 | MAPbI₃ | PEA₂PbI₄ | 1 | 2D | 25 | 20 | PEA₂Pb I₄ | 20 | 16.0% | 91% |
| Compar ative Embodi ment 1 | MAPbI₃ | / | / | / | / | / | / | / | 13.0% | 12% |
| Compar ative Embodi ment 2 | MAPbI₃ | / | / | / | / | / | PEA₂Pb I₄ | 20 | 12.8% | 20% |

**Table 2 Experimental results of Embodiment 1 and Embodiments 25 to 30**

| | d2/nm | d3/nm | d4/nm | d5/nm | d6/nm | Battery efficiency/% | Efficiency retention rate after 1000 h of storage/% |
|---|---|---|---|---|---|---|---|
| Embodiment 1 | 500 | 100 | 500 | 20 | 31 | 14% | 78% |
| Embodiment 25 | 300 | 10 | 300 | 10 | 20 | 12% | 79% |
| Embodiment 26 | 300 | 50 | 300 | 50 | 10 | 13% | 77% |
| Embodiment 27 | 400 | 80 | 400 | 50 | 10 | 14% | 79% |
| Embodiment 28 | 500 | 100 | 500 | 25 | 35 | 12% | 80% |
| Embodiment 29 | 600 | 120 | 600 | 25 | 35 | 13% | 80% |
| Embodiment 30 | 800 | 200 | 800 | 30 | 50 | 12% | 79% |

Combined with Comparative Embodiment 1 and Embodiments 1 to 24, along the first direction, the low-dimensional perovskite layers 54 are disposed on the regions on the two sides of the connection structure 31 opposite to the first perovskite layers 53. The efficiency and life of the perovskite battery 1 are significantly improved.

Combined with Embodiments 11 to 13, along the first direction, the low-dimensional perovskite layers 54 are disposed on the regions on the two sides of the first isolation structure opposite to the first perovskite layers. Compared with Embodiment 1, the life of the perovskite battery 1 is improved to a certain extent.

Combined with Embodiments 14 to 15, the perovskite battery 1 with the stacked structure has a relatively high life while having relatively high efficiency.

Combined with Embodiments 16 to 17, in a case that the low-dimensional perovskites are zero-dimensional perovskites and one-dimensional perovskites, the perovskite battery 1 has relatively high efficiency and life.

Combined with Embodiments 1 to 24, in a case that n is less than or equal to 5, the perovskite battery 1 has relatively high efficiency and life.

Combined with Comparative Embodiment 2 and Embodiment 1, it is difficult to realize a relatively high battery life and efficiency by only disposing the low-dimensional perovskite layers 54 on the two sides of the first isolation structure 32.

Combined with Embodiments 25 to 30 in Table 2, by reasonably setting the thicknesses of the first electrode layer 51, the second electrode layer 52, the first perovskite layer 53, the first charge transport layer 61 and the second charge transport layer 62, a superior battery efficiency and life can be realized.

It is hereby noted that the present application is not limited to the foregoing embodiments. The foregoing embodiments are illustrative merely, and any and all embodiments with substantively the same constituents or exerting the same effects as the technical ideas hereof without departing from the scope of the technical solutions of the present application still fall within the technical scope of the present application. In addition, all kinds of variations of the embodiments conceivable by a person skilled in the art and any other embodiments derived by combining some constituents of the embodiments hereof without departing from the subject-matter of the present application still fall within the scope of the present application.

## Claims

1. A perovskite battery, comprising:
a plurality of battery units (20) arranged along a first direction, each battery unit (20) comprising a first electrode layer (51), a second electrode layer (52), and a first perovskite layer (53) between the first electrode layer (51) and the second electrode layer (52) that are arranged along a second direction; and
a connection structure (31) that is configured to connect a first electrode layer (51) of a first battery unit (21) to a second electrode layer (52) of a second battery unit (22) that are adjacent among the plurality of battery units (20),
wherein low-dimensional perovskite layers (54) are disposed on regions on two sides of the connection structure (31) opposite to the first perovskite layers (53).

2. The perovskite battery according to claim 1, **characterized in that** the low-dimensional perovskite layers (54) have a structural formula of (NH³⁺-R-NH³⁺)Aₙ₋₁BₙX₃ₙ₊₁ or (R-NH³⁺)₂Aₙ₋₁BₙX₃ₙ₊₁, and n ≤ 5, wherein
R comprises at least one of phenyl, aryl, alkyl or a piperidine derivative;
A comprises at least one of Cs, FA, MA, Rb or K;
B comprises at least one of Pb²⁺ or Sn²⁺; and
X comprises at least one of F⁻, Cl⁻, Br⁻ or I⁻.

3. The perovskite battery according to claim 1 or 2, **characterized in that** the perovskite battery further comprises a first isolation structure (32), the first isolation structure (32) is configured to isolate a second electrode layer (52) of the first battery unit (21) from the second electrode layer (52) of the second battery unit (22), and the first isolation structure (32) is spaced apart from the connection structure (31).

4. The perovskite battery according to claim 3, **characterized in that** the battery unit (20) comprises the first electrode layer (51), a first charge transport layer (61), the first perovskite layer (53), a second charge transport layer (62) and the second electrode layer (52) that are sequentially disposed on a substrate (50).

5. The perovskite battery according to claim 4, **characterized in that** the first isolation structure (32) is an insulation structure that extends from a first surface (521) of the second electrode layer (52) to at least the first charge transport layer (61), and the first surface (521) of the second electrode layer (52) is a surface of the second electrode layer (52) away from the first electrode layer (51); and
the low-dimensional perovskite layers (54) are disposed on regions on two sides of the first isolation structure (32) opposite to the first perovskite layers (53).

6. The perovskite battery according to any one of claims 3 to 5, **characterized in that** along the first direction, a distance (k1) between the first isolation structure (32) and the connection structure (31) is 5 µm to 25 µm.

7. The perovskite battery according to any one of claims 3 to 6, **characterized in that** the connection structure (31) is a conductive structure that extends from a second surface (522) of the second electrode layer (52) to the first electrode layer (51), and the second surface (522) of the second electrode layer (52) is a surface of the second electrode layer (52) close to the first electrode layer (51).

8. The perovskite battery according to any one of claims 4 to 7, **characterized in that** the battery unit (20) further comprises a light absorption layer (59) located between the first electrode layer (51) and the second electrode layer (52).

9. The perovskite battery according to claim 8, **characterized in that** the light absorption layer (59) comprises a second perovskite layer (56), the battery unit (20) further comprises a third electrode layer (55), a third charge transport layer (63), the second perovskite layer (56) and a fourth charge transport layer (64) that are located between the second charge transport layer (62) and the second electrode layer (52) and sequentially disposed, and the low-dimensional perovskite layers (54) are disposed on regions on the two sides of the connection structure (31) opposite to the second perovskite layers (56).

10. The perovskite battery according to claim 9, **characterized in that** the low-dimensional perovskite layers (54) are disposed on regions on the two sides of the first isolation structure (32) opposite to the second perovskite layers (56).

11. The perovskite battery according to claim 9 or 10, **characterized in that** a band gap of the first perovskite layer (53) is greater than a band gap of the second perovskite layer (56).

12. The perovskite battery according to claim 8, **characterized in that** the light absorption layer (59) comprises a copper indium gallium selenide layer (58), and the battery unit (20) further comprises a fifth charge transport layer (65), the copper indium gallium selenide layer (58), a sixth charge transport layer (66) and a fourth electrode layer (57) that are located between the first electrode layer (51) and the second charge transport layer (62) and sequentially disposed.

13. The perovskite battery according to any one of claims 1 to 12, **characterized in that** the low-dimensional perovskite layers (54) have a thickness (d1) of 1 nm to 100 nm, and optionally, 1 nm to 4 nm.

14. The perovskite battery according to any one of claims 1 to 13, **characterized in that** the low-dimensional perovskite layers (54) are one-dimensional perovskite layers.

15. The perovskite battery according to any one of claims 1 to 14, **characterized in that** the second electrode layer (52) and the connection structure (31) are of a one-piece molded structure.

16. The perovskite battery according to any one of claims 1 to 15, **characterized in that** a material of the first electrode layer (51) comprises at least one of indium tin oxide, indium zinc oxide, tungsten-doped indium oxide, gallium-doped zinc oxide, aluminum zinc oxide or fluorine-doped tin oxide.

17. The perovskite battery according to any one of claims 1 to 16, **characterized in that** a material of the second electrode layer (52) comprises at least one of indium tin oxide, indium zinc oxide, tungsten-doped indium oxide, gallium-doped zinc oxide, aluminum zinc oxide, Au, Ag, Cu, Al, Ni, Cr, Bi, Pt, Mg, Mo, W or alloy thereof, and a carbon material; and optionally, the carbon material comprises at least one of carbon black, graphene or a carbon nanotube.

18. The perovskite battery according to any one of claims 1 to 17, **characterized in that** the first electrode layer (51) has a thickness (d2) of 300 nm to 800 nm, the second electrode layer (52) has a thickness (d3) of 10 nm to 200 nm, and the first perovskite layer (53) has a thickness (d4) of 300 nm to 800 nm; and optionally, the first electrode layer (51) has a thickness (d2) of 400 nm to 600 nm, the second electrode layer (52) has a thickness (d3) of 80 nm to 120 nm, and the first perovskite layer (53) has a thickness (d4) of 400 nm to 600 nm.

19. The perovskite battery according to any one of claims 1 to 18, **characterized in that** the first perovskite layer (53) has a structural formula of ABX₃, wherein A has an ionic radius of 0.076 nm to 0.315 nm, B has an ionic radius of 0.06 nm to 0.15 nm, and X has an ionic radius of 0.1 nm to 0.2 nm;
optionally, A comprises at least one of an organic amine cation, Cs, K, Rb or Li, B comprises at least one of lead, tin, zinc, titanium, antimony, bismuth, nickel, iron, cobalt, silver, copper, gallium, germanium, magnesium, calcium, indium, aluminum, manganese, chromium, molybdenum or europium, and X comprises at least one of fluorine, chlorine, bromine or iodine; and
optionally, the organic amine cation comprises at least one of a methylamine ion or a formamidine ion.

20. The perovskite battery according to any one of claims 4 to 19, **characterized in that** the first charge transport layer (61) is a hole transport layer, and the second charge transport layer (62) is an electron transport layer; or the first charge transport layer (61) is the electron transport layer, and the second charge transport layer (62) is the hole transport layer.

21. The perovskite battery according to claim 20, **characterized in that** a material of the hole transport layer comprises a P-type semiconductor, and a material of the electron transport layer comprises an N-type semiconductor;
optionally, the material of the hole transport layer comprises at least one of thiophene, phthalocyanine, porphyrin, Spiro-OMeTAD, molybdenum oxide, vanadium pentoxide, tungsten oxide, nickel oxide, copper oxide, tin oxide, molybdenum disulfide, tungsten sulfide, copper sulfide, tin sulfide, cuprous thiocyanate, cuprous iodide, fluoro-containing phosphonic acid, carbonyl-containing phosphonic acid, a carbon nanotube or graphene; and
optionally, the material of the electron transport layer comprises at least one of [6,6]-phenyl-C₆₁-methyl isobutyrate, C₆₀, cyano-containing polyphenylacetylene, a boracic polymer, bathocuproine, bathophenanthroline, hydroxyquinoline aluminum, an oxadiazole compound, a benzimidazole compound, a naphthalene tetracarboxylic acid compound, a perylene derivative, a phosphine oxide compound, a phosphine sulfide compound, fluoro-containing phthalocyanine, titanium oxide, zinc oxide, indium oxide, tin oxide, gallium oxide, tin sulfide, indium sulfide, lithium fluoride, sodium fluoride, magnesium fluoride or zinc sulfide.

22. The perovskite battery according to any one of claims 4 to 21, **characterized in that** the first charge transport layer (61) has a thickness (d5) of 10 nm to 200 nm, and the second charge transport layer (62) has a thickness (d6) of 10 nm to 200 nm.

23. The perovskite battery according to any one of claims 4 to 22, **characterized in that** a material of the substrate (50) comprises at least one of glass or a transparent flexible polymer; and optionally, the transparent flexible polymer comprises at least one of polyethylene terephthalate or polyimide.

24. An electrical apparatus, comprising the perovskite battery according to any one of claims 1 to 23, the perovskite battery being configured to supply power to the electrical device.

25. A method for preparing a perovskite battery, comprising:
providing (310) a plurality of battery units (20) arranged along a first direction, each battery unit (20) comprising a first electrode layer (51), a second electrode layer (52), and a first perovskite layer (53) between the first electrode layer (51) and the second electrode layer (52) that are arranged along a second direction; and
providing (320) a connection structure (31) that is configured to connect a first electrode layer (51) of a first battery unit (21) to a second electrode layer (52) of a second battery unit (22) that are adjacent among the plurality of battery units (20), wherein low-dimensional perovskite layers (54) are disposed on regions on two sides of the connection structure (31) opposite to the first perovskite layers (53).

26. The method according to claim 25, **characterized in that** the providing (310) a plurality of battery units (20) arranged along a first direction comprises:
providing a substrate (50), the first electrode layer (51) being disposed on the substrate (50);
sequentially depositing a first charge transport layer (61), a first perovskite layer (53) and a second charge transport layer (62) on the first electrode layer (51); and
depositing a second electrode layer (52) on the second charge transport layer (62), and
the providing (320) a connection structure (31) comprises:
etching the second charge transport layer (62) along the second direction to expose the first electrode layer (51), thus forming a first etched bath; and
covering a solution containing low-dimensional perovskite cations on two opposite surfaces of the first etched bath along the first direction to prepare the low-dimensional perovskite layers (54) between the connection structure (31) and the first perovskite layers (53).

27. The method according to claim 25 or 26, **characterized in that** the method further comprises:
providing a first isolation structure (32), wherein the low-dimensional perovskite layers (54) are disposed on regions on two sides of the first isolation structure (32) opposite to the first perovskite layers (53);
the providing a first isolation structure (32) comprises:
etching the second electrode layer (52) along the second direction to expose the first electrode layer (51), thus forming a second etched bath; and
covering a solution containing low-dimensional perovskite cations on two opposite surfaces of the second etched bath along the first direction to prepare the low-dimensional perovskite layers (54) between the first isolation structure (32) and the first perovskite layers (53).
